# EUROPEAN PATENT SPECIFICATION

(11) **EP 4 199 663 B1**
(45) Date of publication and mention of the grant of the patent: **09.12.2026**
(21) Application number: 21862166.2
(22) Date of filing: 31.08.2021
(51) Int. Cl.: H04M 1/02, C25D 11/02, C25D 11/12, C25D 11/22, C25D 11/24, C25D 11/16

(54) **ELECTRONIC DEVICE AND ELECTRONIC DEVICE HOUSING STRUCTURE**
ELEKTRONISCHE VORRICHTUNG UND GEHÄUSESTRUKTUR FÜR ELEKTRONISCHE VORRICHTUNG
DISPOSITIF ÉLECTRONIQUE ET STRUCTURE DE BOÎTIER DE DISPOSITIF ÉLECTRONIQUE

(30) Priority: 31.08.2020 KR 20200110390
(43) Date of publication of application: 21.06.2023
(73) Proprietor: Samsung Electronics Co., Ltd., Suwon-si, Gyeonggi-do 16677 (KR)
(72) Inventor: LEE, Heesung, Suwon-si, Gyeonggi-do 16677 (KR); KIM, Goeun, Suwon-si, Gyeonggi-do 16677 (KR); KIM, Inkyu, Suwon-si, Gyeonggi-do 16677 (KR); KIM, Hyunsoo, Suwon-si, Gyeonggi-do 16677 (KR); PARK, Hyesun, Suwon-si, Gyeonggi-do 16677 (KR); SONG, Kyunghwan, Suwon-si, Gyeonggi-do 16677 (KR); CHEON, Aro, Suwon-si, Gyeonggi-do 16677 (KR); HEO, Youngjun, Suwon-si, Gyeonggi-do 16677 (KR); KIM, Kyungtae, Suwon-si, Gyeonggi-do 16677 (KR); PARK, Seokjin, Suwon-si, Gyeonggi-do 16677 (KR); CHOI, Hyunsuk, Suwon-si, Gyeonggi-do 16677 (KR)
(74) Representative: HGF
(86) International application number: PCT/KR2021/011706
(87) International publication number: WO 2022/045870

(56) References cited:
- WO-A1-2020/013481
- WO-A1-2020/159166
- KR-A- 20160 149 792
- KR-A- 20170 134 001
- KR-A- 20180 088 157
- KR-A- 20200 099 733
- KR-B1- 101 568 343

## Description

### [Technical Field]

Various disclosure disclosed herein relate to an electronic device and an electronic device housing structure.

### [Background Art]

In line with development of information/communication technologies and semiconductor technologies, there has been widespread use of various kinds of electronic devices. Particularly, recent electronic devices have been developed to be carried and used for communication. Furthermore, electronic devices may output stored information as sounds or images. In line with the high degree of integration of electronic devices and the widespread use of super-fast large-capacity wireless communication, it has recently become possible to equip a single electronic device (for example, mobile communication terminal) with various functions. For example, not only a communication function, but also an entertainment function (for example, gaming), a multimedia function (for example, music/video playback), communication and security functions for mobile banking, a scheduling function, and an electronic wallet function may be integrated into a single electronic device. Such electronic devices have become compact such that users can conveniently carry the same.

There has been ongoing research, in connection with fabricating a housing suppose to constitute the exterior of an electronic device by utilizing a metal material such that various circuit devices and the like are protected from external environments, and the electronic device has an aesthetic appearance.
WO2020013481A1 relates to an electronic device that includes a housing, a first glass plate coupled to the housing and defining an inner space, the first glass plate including a peripheral portion including: a first, second, third, fourth, and fifth surface forming an edge of the glass plate, the first and fifth surfaces being substantially parallel and the third surface being substantially perpendicular to the first and fifth surfaces, a decorative layer formed of a first material, disposed on a first area of the fifth surface such that a second area disposed between the fourth surface and the first area is uncovered by the decorative layer, and a protective layer formed of a second material, covering the second surface, the third surface, the fourth surface, the second area of the fifth surface, and a part of the decorative layer.
WO2020159166A1 relates to an electronic device including a first plate including a first flat surface portion facing a first direction, wherein first plate forms a first surface of the electronic device; a second plate including a second flat surface portion facing a second direction opposite the first direction, wherein the second plate forms a second surface of the electronic device; a side member including a first metal part including a first metallic material and forming at least part of a third surface between the first surface and the second surface and a second metal part including a second metallic material, wherein the second metal part is bonded with the first metal part; and display disposed between the first plate and the second plate so as to be shown through the first plate, wherein the first metal part and the second metal part form an interface including the first metallic material and the second metallic material, and wherein the interface is configured to face a third direction that is perpendicular to the first direction and the second direction.
KR20200099733A relates to an electronic device that includes a foldable housing including: a hinge structure; a first housing structure connected to the hinge structure and including a first surface in a first direction, a second surface opposite in direction to the first surface, and a first side member surrounding a first space between the first and second surfaces; and a second housing structure connected to the hinge structure and including a third surface in a second direction, a fourth surface opposite in direction to the third surface, and a second side member surrounding a second space between the third and fourth surfaces. The first and second housing structures are coupled so as to be mutually foldable along the hinge structure so as to face each other at least in part in the folded state. The first side member includes: a first side surface having a first length; a second side surface having a second length shorter than the first length and extending in the direction of the hinge structure from the first side surface through a first corner having a first curvature radius; a third side surface extending from the second side surface through a second corner having a second curvature radius smaller than the first curvature radius so as to face the hinge structure at least in part; and a processing region extending from the first side surface to the third side surface through the second side surface. The vertical distance between a first boundary line between the processing region and the first surface and a second boundary line between the processing region and the second surface may be substantially equal on the first side surface, the second side surface, or the third side surface.
KR20170134001A relates to a housing of an electronic device which includes a first surface facing a first direction, a second surface facing a second direction opposite to the first direction, and a lateral side surrounding at least a part of a space formed between the first surface and the second surface. A first region of at least one side of the housing includes a first surface layer to which a first texture and a first color are applied and a second region which is a part of the first region includes a second surface layer to which a second texture and a second color are applied. At least one of the first surface layer and the second surface layer includes an oxide film layer.

### [Detailed Description of the Invention]

### [Technical Problem]

Aluminum metal is used as the exterior material of a portable electronic device. in order to use aluminum metal as the exterior material of an electronic device, typical processing processes such as a cutting process, an injection process, and a surface treatment process may be performed. For example, in the cutting process, the metal exterior material is turned into a desired shape by using cutting machines (for example, CNC, diamond cut, polishing). In the injection process, synthetic resin melted at a
high temperature is injected into a metal exterior material component prepared in a mold such that the resin and the metal are bonded. For example, in the surface treatment process, anodizing may be used. During anodizing, a metal is electrically connected to the anode and is oxidated together with oxygen such that the surface of the metal is treated with the generated aluminum oxide film. Anodizing is widely used because the surface is hard and anti-corrosive, and can be easily colored by using the film.

In order to improve the aesthetic appeal of electronic devices, there have been increasing design-related demands for housings for implementing various shapes or various colors.

According to conventional exterior material processing processes, it is difficult to implement two or more colors on a single electronic device and, even if implemented, a large number of complicated processes may be necessary. For example, when two colors are implemented on a single electronic device, a film may be formed through primary anodizing to implement the first color, a coloring process may be performed regarding the first color, and sealing may be performed regarding the same. In order to implement the second color, the section to be colored with different colors may be cut or polished to remove the primary anodizing film, another film may be formed through secondary anodizing, and a coloring process may be performed regarding the second color. As another example, after partially making an electronic device, primary anodizing, coloring, and sealing may be performed. After removing the mask, an oxide film may be formed through secondary anodizing, and secondary coloring may be performed.

According to the above-mentioned embodiments, the primary film having the first color may be damaged during the cutting or polishing process, thereby affecting the product quality and durability, and the processes may be complicated and may require a long time. There may be another problem in that manufacturing costs may be increased by the masking process and the demasking process, and the defective ratio may depend on the accuracy of masking.

Various embodiments of the disclosure may provide an electronic device and an electronic device housing structure, wherein various colors can be implemented on the housing because the housing can be colored with different colors through a secondary anodizing process performed continuously after a primary anodizing process.

Problems to be solved by the disclosure are not limited to the above-mentioned problems, and may be variously expanded without deviating from the idea and scope of the disclosure.

### [Technical Solution]

The scope of the invention is set out in the appended claims.

According to various embodiments disclosed in the document, an electronic device may include a housing including: a front plate; a rear plate facing in a direction opposite to the front plate; a side member configured to surround a space between the front plate and the rear plate; and a support member disposed in the space, wherein a substantial part of the housing is configured by an electrically conductive material and the substantial part is divided into a first portion and a second portion electrically separated from the first portion, and the first portion is colored with a first color and the second portion is colored with a second color different from the first color.

According to various embodiments disclosed in the document, a housing manufacturing method may include: a process of processing a housing including a metal member; a primary anodizing process of forming a predetermined oxide film on a first portion of the metal member; a process of coloring and treating the oxide film formed on the first portion by using a coloring material having a first color; a secondary anodizing process of forming a predetermined oxide film on a second portion of the metal member; and a process of coloring and treating the oxide film formed on the second portion by using a coloring material having a second color.

According to various embodiments disclosed in the document, an electronic device may include a housing including: a front plate; a rear plate facing in a direction opposite to the front plate; a side member configured to surround a space between the front plate and the rear plate; and a support member disposed in the space, wherein at least a portion of the housing is divided into a first portion configured by an electrically conductive material and a second portion which is configured by an electrically conductive material and electrically separated from the first portion, the first portion includes a first outer wall which is colored with a first color of first color series and faces the outside of the housing and a first inner wall facing in a direction opposite to the first outer wall, and the second portion includes a second outer wall which is colored with a first color of second color series and faces the outside of the housing and a second inner wall facing in a direction opposite to the second outer wall.

### [Advantageous Effects]

An electronic device according to various embodiments disclosed herein is advantageous in that the outer wall and inner wall of the electronic device may be colored with multiple colors, thereby implementing differentiated exterior design.

Various embodiments disclosed herein may provide a method for performing anodizing continuously without performing complicated processes such as additional processing, polishing, or mashing, thereby reducing costs and improving productivity.

Various embodiments disclosed herein may provide a method including a continuous anodizing process applicable not only to the exterior frame of a portable electronic device, but also to a group of various products having metal exterior materials.

### [Brief Description of Drawings]

FIG. 1 a block diagram of an electronic device in a network environment according to various embodiments disclosed in the document.
FIG. 2 is a front perspective view of an electronic device according to various embodiments disclosed in the document.
FIG. 3 is a rear perspective view of an electronic device according to various embodiments disclosed in the document.
FIG. 4 is an exploded perspective view of an electronic device according to various embodiments disclosed in the document.
FIG. 5 is views showing the front surface, the side surfaces, and the rear surface of an electronic device according to various embodiments disclosed in the document.
FIG. 6A is perspective views showing the front surface and the rear surface of an electronic device according to another embodiment disclosed in the document.
FIG. 6B is perspective views showing the rear surface of an electronic device according to various embodiments disclosed in the document.
FIG. 7A is a view showing a form in which a first color is applied on a side member including a portion segmented by slits according to an embodiment.
FIG. 7B is a view showing a form in which a first color and a second color are colored on a side member including a portion segmented by slits according to an embodiment.
FIG. 8 is a detailed view of a housing provided with a segmented portion according to various embodiments disclosed in the document.
FIG. 9A is a flowchart showing a housing structure manufacturing method including an anodizing method according to some embodiments.
FIG. 9B is a flowchart showing a housing structure manufacturing method including an anodizing method according to various embodiments of the disclosure.
FIG. 10 is a view showing a jig used for performing an anodizing process according to various embodiments of the disclosure.
FIG. 11A is a view showing a form in which a jig is mounted to a housing according to various embodiments of the disclosure.
FIG. 11B is a view showing a use aspect of a jig used for performing an anodizing process according to various embodiments of the disclosure.
FIG. 12 is view showing implemented examples by a continuous anodizing process according to various embodiments of the disclosure.
FIG. 13 is a view showing an application example of a continuous anodizing process according to various embodiments of the disclosure.
FIG. 14 is a perspective view showing a wearable electronic device having a housing, the exterior of which are colored by various colors in a continuous anodizing method.
FIG. 15 is a front view showing a wearable electronic device in which various colors are implemented on the exterior of a housing by using a continuous anodizing method.

### [Brief Description of Drawings]

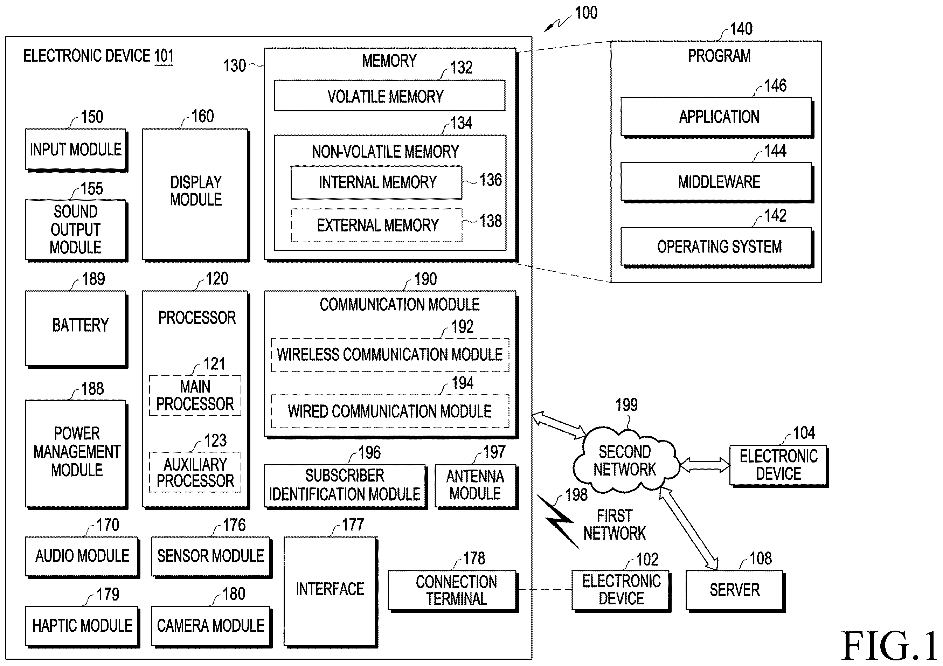

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 or 104 may be a device of a same type as, or a different type, from the electronic device 101. According to an embodiment, all or some of operations to be executed at the electronic device 101 may be executed at one or more of the external electronic devices 102, 104, or the server 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the
terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

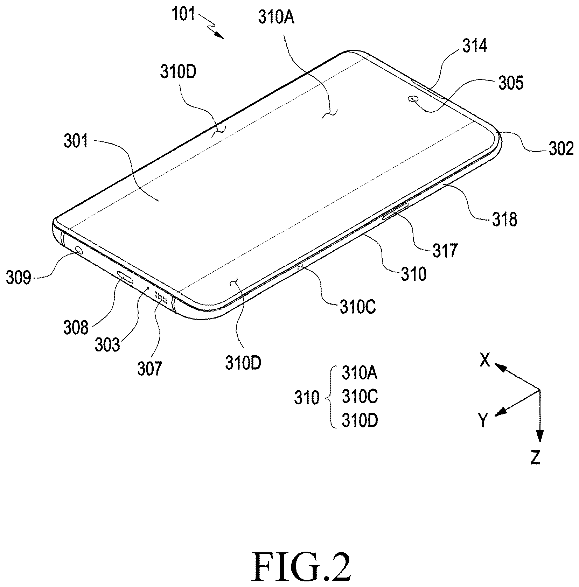

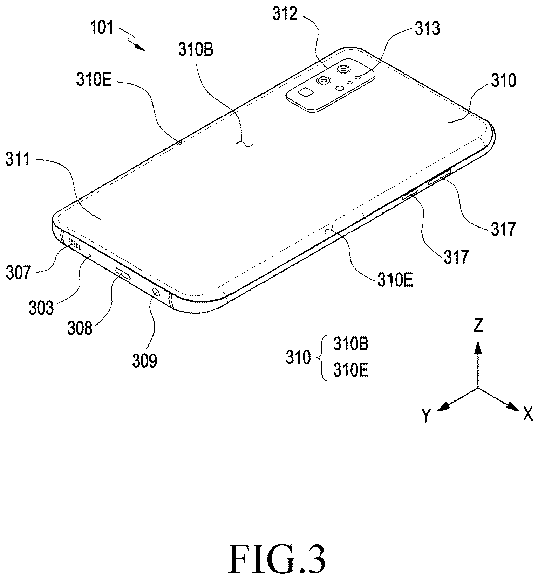

FIG. 2 is a front perspective view of an electronic device according to various embodiments of the disclosure. FIG. 3 is a rear perspective view of an electronic device according to various embodiments of the disclosure.

Referring to FIG. 2 and FIG. 3, an electronic device 101 according to an embodiment may include a housing 310 including a front surface 310A, a rear surface 310B, and a side surface 310C for surrounding a space between the front surface 310A and the rear surface 310B. In another embodiment (not shown), the housing 310 may also be referred to as a structure which forms a portion of the front surface 310A in FIG. 2, and the rear surface 310B and the side surface 310C in FIG. 3. According to an embodiment, the front surface 310A may be formed by a front plate 302 (e.g., a glass plate including various coating layers, or a polymer plate) of which at least a portion is substantially transparent. The rear surface 310B may be formed by a rear plate 311. For example, the rear plate 311 may be formed of glass, ceramic, polymer, metal (e.g., aluminum, stainless steel (STS), or magnesium), or a combination of at least two of the above materials. The side surface 310C may be coupled to the front plate 302 and the rear plate 311, and may be formed by a side bezel structure (or "a side member") 318 including metal and/or polymer. In some embodiments, the rear plate 311 and the side bezel structure 318 may be integrally formed, and may include the same material (e.g., glass, a metal material such as aluminum, or ceramic).

In the illustrated embodiment, the front plate 302 may include two first edge areas 310D which are bent from the front surface 310A toward the rear plate 311 so as to extend seamlessly, and provided at opposite long edge ends of the front plate 302. In the illustrated embodiment (see FIG. 3), the rear plate 311 may include two second edge areas 310E which are bent from the rear surface 310B toward the front plate 302 so as to extend seamlessly, and provided at opposite long edge ends thereof. In some embodiments, the front plate 302 (or the rear plate 311) may include only one of the first edge areas 310D (or the second edge areas 310E). In another embodiment, a portion of the first edge areas 310D or the second edge areas 310E may not be included therein. In the embodiments, when seen from the side surface of the electronic device 101, the side bezel structure 318 may have a first thickness (or width) in the side of the side surface not including the first edge areas 310D or the second edge areas 310E, and may have a second thickness thinner than the first thickness in the side of the side surface including the first edge areas 310D or the second edge areas 310E.

According to an embodiment, the electronic device 101 may include at least one of a display 301, audio modules 303, 307, and 314 (e.g., the audio module 170 in FIG. 1), a sensor module (e.g., the sensor module 176 in FIG. 1), camera modules 305, 312, and 313 (e.g., the camera module 180 in FIG. 1), a key input device 317 (e.g., the input moudle150 in FIG. 1), and connector holes 308 and 309 (e.g., the connection terminal 178 in FIG. 1). In some embodiments, at least one (e.g., the connector hole 309) of elements may be omitted from the electronic device 101, and other components may be additionally included therein.

According to an embodiment, for example, the display 301 may be visually exposed through a significant portion of the front plate 302. In some embodiments, at least a portion of the display 301 may be exposed through the front surface 310A and the front plate 302 forming the first edge areas 310D. In some embodiments, the corners of the display 301 may be formed to have shapes substantially the same as the shapes of the outer perimeters of the front plate 302, which are adjacent thereto. In another embodiment (not shown), in order to expand an area which allows the display 301 to be exposed, there may be no gap between the outer perimeter of the display 301 and the outer perimeter of the front plate 302.

According to an embodiment, a surface (or the front plate 302) of the housing 310 may include a screen display area formed as the display 301 is visually exposed. As an example, the screen display area may include the front surface 310A and the first edge areas 310D.

In another embodiment (not shown), a recess or an opening may be formed in a portion of the screen display area (e.g., the front surface 310A or the first edge areas 310D) of the display 301, and at least one of the audio module 314, a sensor module (not shown), a light-emitting element (not shown), and the camera module 305 which are aligned with the recess or the opening may be included therein. In another embodiment (not shown), at least one of the audio module 314, a sensor module (not shown), the camera module 305, a fingerprint sensor (not shown), and a light-emitting element (not shown) may be included on the rear surface of the screen display area of the display 301.

In another embodiment (not shown), the display 301 may be coupled to or disposed adjacent to a touch detection circuit, a pressure sensor capable of measuring the intensity (pressure) of touch, and/or a digitizer for detecting a magnetic field-type stylus pen.

In some embodiments, at least a portion of the key input device 317 may be disposed in the first edge areas 310D and/or the second edge areas 310E.

According to an embodiment, for example, the audio module 303, 307, or 314 may include a microphone hole 303 and speaker holes 307 and 314. A microphone for obtaining external sound may be disposed in the microphone hole 303, and in some embodiments, multiple microphones may be arranged to be able to detect the direction of sound. The speaker holes 307 and 314 may include an external speaker hole 307 and a receiver hole 314 for phone calls. In some embodiments, the speaker holes 307 and 314 and the microphone hole 303 may be implemented as one hole, or a speaker (e.g., a piezo speaker) may be included therein without the speaker holes 307 and 314. The audio modules 303, 307, and 314 are not limited to the structure, and a structure thereof may be variously changed as only some audio modules are mounted or a new audio module is added according to a structure of the electronic device 101.

According to an embodiment, for example, a sensor module (not shown) may generate an electrical signal or a data value corresponding to an internal operation state of the electronic device 101 or an external environmental state. For example, a sensor module (not shown) may include a first sensor module (not shown) (e.g., a proximity sensor) and/or a second sensor module (not shown) (e.g., a fingerprint sensor) disposed on the front surface 310A of the housing 310, and/or a third sensor module (not shown) (e.g., an fiRM sensor) and/or a fourth sensor module (not shown) (e.g., a fingerprint sensor) disposed on the rear surface 310B of the housing 310. In some embodiments (not shown), the fingerprint sensor may be disposed on the rear surface 310B as well as the front surface 310A (e.g., the display 301) of the housing 310. The electronic device 101 may further include a sensor module not illustrated, for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor (not shown). The sensor module (not shown) is not limited to the structure, and a structure thereof may be variously changed as only some sensor modules are mounted or a new sensor module is added according to a structure of the electronic device 101.

According to an embodiment, for example, the camera modules 305, 312, and 313 may include a front camera module 305 disposed on the front surface 310A of the electronic device 101, and a rear camera module 312 and/or a flash 313 disposed on the rear surface 310B. The camera modules 305 and 312 each may include one lens or multiple lenses, an image sensor, and/or an image signal processor. For example, the
flash 313 may include a light-emitting diode or a xenon lamp. In some embodiments, two or more lenses (an infrared camera, a wide-angle lens, and a telephoto lens) and image sensors may be arranged on one surface of the electronic device 101. The camera modules 305, 312, and 313 are not limited to the structure, and a structure thereof may be variously changed as only some camera modules are mounted or a new camera module is added according to a structure of the electronic device 101.

According to an embodiment, the electronic device 101 may include multiple camera modules (e.g., a dual camera or a triple camera) having different properties (e.g., a view angle) or functions. For example, the camera module 305 or 312 including lenses having different view angles may be configured to have multiple camera modules, and the electronic device 101 may control to change a view angle of the camera modules 305 and 312, which is performed in the electronic device 101, based on a user selection. For example, at least one of the multiple camera modules 305 and 312 may be a wide-angle camera, and at least the other thereof may be a telephoto camera. Similarly thereto, at least one of the multiple camera modules 305 and 312 may be a front camera, and at least the other thereof may be a rear camera. In addition, the multiple camera modules 305 and 312 may include at least one of a wide-angle camera, a telephoto camera, or an infrared (IR) camera (e.g., a time of flight (TOF) camera or a structured light camera). According to an embodiment, the IR camera may also operate as at least a portion of a sensor module. For example, the TOF camera may also operate as at least a portion of a sensor module (not shown) for detecting a distance to a subject.

According to an embodiment, the key input device 317 may be disposed on the side surface 310C of the housing 310. In another embodiment, the electronic device 101 may not include a portion or the whole of key input device 317 mentioned above, and the key input device 317 not included therein may be implemented as a different type such as a soft key, on the display 301. In some embodiments, the key input device may include a sensor module (not shown) disposed on the rear surface 310B of the housing 310.

According to an embodiment, for example, a light-emitting element (not shown) may be disposed on the front surface 310A of the housing 310. For example, the light-emitting element (not shown) may provide state information of the electronic device 101 in the form of light. In another embodiment, for example, the light-emitting element (not shown) may provide a light source operating in association with an operation of the front camera module 305. For example, the light-emitting element (not shown) may include an LED, an IR LED, and/or a xenon lamp.

According to an embodiment, for example, the connector holes 308 and 309 may include a first connector hole 308 capable of accommodating a connector (for example, a USB connector) for transmitting or receiving power and/or data to or from an external electronic device, and/or a second connector hole 309 (for example, an earphone jack) capable of accommodating a connector for transmitting or receiving audio signals to or from an external electronic device. The connector holes 308 and 309 are not limited to the structure, and a structure thereof may be variously changed as only some connector holes are mounted or a new connector hole is added according to a structure of the electronic device 101.

According to an embodiment, the camera module 305 and/or the sensor module (not shown) may be disposed so as to be in contact with an external environment through a designated area of the display 301 and the front plate 302, in an inner space of the electronic device 101. For example, the designated area may be an area of the display 301, in which pixels are not arranged. As another example, the designated area may be an area of the display 301, in which pixels are arranged. When seen from above the display 301, at least a portion of the designated area may overlap the camera module 305 and/or sensor modules. As another example, some sensor modules may also be arranged to perform the function thereof without being visually exposed through the front plate 302 in the inner space of the electronic device.

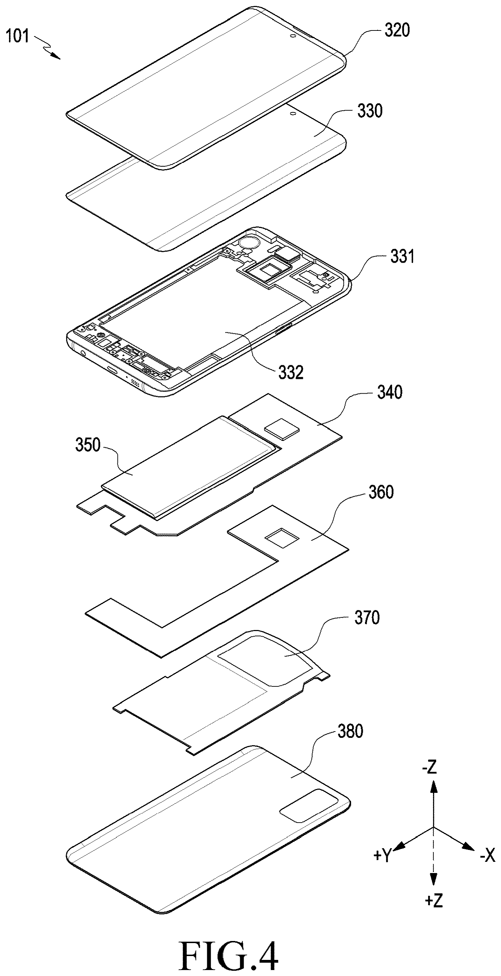

FIG. 4 is an exploded perspective view of an electronic device according to various embodiments of the disclosure.

Referring to FIG. 4, an electronic device 101 (e.g., the electronic device 101 in FIG. 2 and FIG. 3) may include a front plate 320 (e.g., the front plate 302 in FIG. 2), a display 330 (e.g., the display 301 in FIG. 2), a first support member 332 (e.g., a bracket), a main printed circuit board 340 (e.g., a PCB, a flexible PCB (FPCB), or a rigid flexible PCB (RFPCB)), a battery 350, a second support member 360 (e.g., a rear case), an antenna 370, and a rear plate 380 (e.g., the rear plate 311 in FIG. 3). In some embodiments, at least one (e.g., the first support member 332 or the second support member 360) of elements may be omitted from the electronic device 101, or other elements may be additionally included therein. At least one of elements of the electronic device 101 may be the same as or similar to at least one of elements of the electronic device 101 in FIG. 2 or FIG. 3, and overlapping descriptions will be omitted hereinafter.

According to an embodiment, the first support member 332 may be disposed inside the electronic device 101 to be connected to a side bezel structure 331 or to be integrally formed with the side bezel structure 331. For example, the first support member 332 may be formed of a metal material and/or a non-metal (e.g., polymer) material. The display 330 may have one surface to which the first support member 332 is coupled, and the other surface to which the printed circuit board 340 is coupled. The printed circuit board 340 may have a processor, a memory, and/or an interface mounted thereon. For example, the processor may include one or more of a central processing unit, an application processor, a graphic processing device, an image signal processor, a sensor hub processor, or a communication processor. According to an embodiment, the printed circuit board 340 may include a flexible printed circuit board type radio frequency cable (FRC). For example, the printed circuit board 340 may be disposed on at least a portion of the first support member 332, and an antenna module (e.g., the antenna module 197 in FIG. 1) and a communication module (e.g., the communication module 190 in FIG. 1) may be electrically connected.

According to an embodiment, for example, the memory may include a volatile memory or a non-volatile memory.

According to an embodiment, for example, the interface may include a high-definition multimedia interface (HDMI), a universal serial bus (USB) interface, an SD card interface, and/or an audio interface. For example, the interface may electrically or physically connect the electronic device 101 to an external electronic device, and may include a USB connector, an SD card/MMC connector, or an audio connector.

According to an embodiment, the battery 350 may be a device for supplying power to at least one element of the electronic device 101, and for example, may include a non-rechargeable primary cell, a rechargeable secondary cell, or a fuel cell. For example, at least a portion of the battery 350 may be disposed on substantially the same plane as the printed circuit board 340. The battery 350 may also be integrally disposed inside the electronic device 101, or may be disposed to be detachable/attachable from/to the electronic device 101.

According to an embodiment, the second support member 360 (e.g., a rear case) may also be disposed between the printed circuit board 340 and the antenna 370. For example, the second support member 360 may also include one surface to which at least one of the printed circuit board 340 or the battery 350 is coupled, and the other surface to which the antenna 370 is coupled.

According to an embodiment, the antenna 370 may also be disposed between
the rear plate 380 and the battery 350. For example, the antenna 370 may include a near field communication (NFC) antenna, a wireless charging antenna, and/or a magnetic secure transmission (MST) antenna. For example, the antenna 370 may perform short-range communication with an external device, or may transmit or receive power required for charging wirelessly. For example, the antenna 370 may include a coil for wireless charging. In another embodiment, an antenna structure may be formed by a portion of the side bezel structure 331 and/or the first support member 332, or a combination thereof.

According to various embodiments, the rear plate 380 may form at least a portion of the rear surface (e.g., the rear surface 310B in FIG. 3) of the electronic device 101.

Although the electronic device 101 illustrated in FIG. 2 to FIG. 4 has a bar-type or a plate-type exterior, the disclosure is not limited thereto. For example, the illustrated electronic device may be a portion of a rollable electronic device or a foldable electronic device. A "rollable electronic device" may mean an electronic device in which a display (e.g., the display 330 in FIG. 4) may be bent and transformed so that at least a portion thereof is wound (or rolled), or is accommodated in a housing (e.g., the housing 310 in FIG. 2). According to needs of a user, the rollable electronic device may have a display which is unfoldable or has a larger area exposed to the outside, so as to expand and use a screen display area. A "foldable electronic device" may mean an electronic device in which two different areas of a display can be folded to face each other or to be oriented in directions opposite to each other. Generally, in a carrying state, a display of a foldable electronic device may be configured such that two different areas thereof are folded in a state of facing each other or in opposite directions, and in an actual use state, the display, by a user, may be unfolded such that the two different areas thereof form a substantially flat-plate shape. In some embodiments, the electronic device 101 according to various embodiments disclosed in the document may be interpreted as meaning including various other electronic devices such as a notebook computer or home appliances in addition to a portable electronic device such as a smartphone.

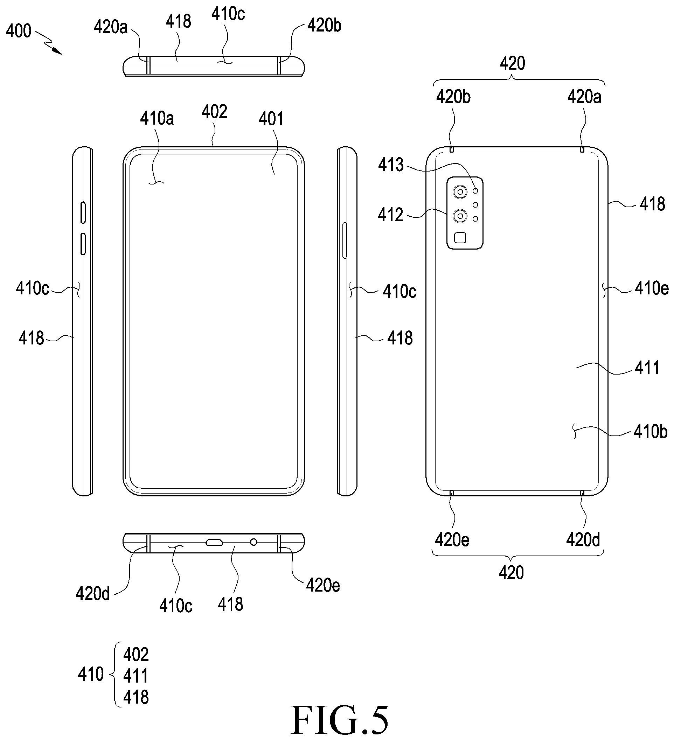

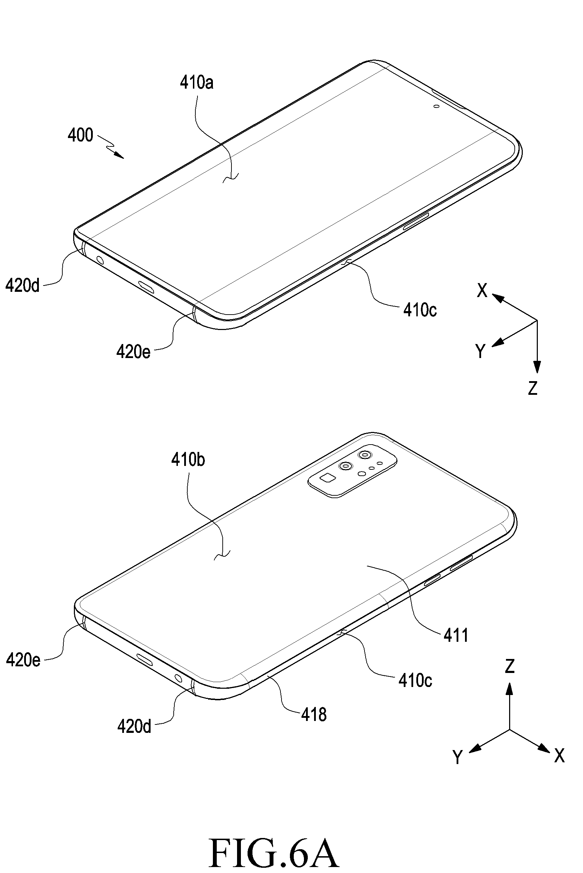

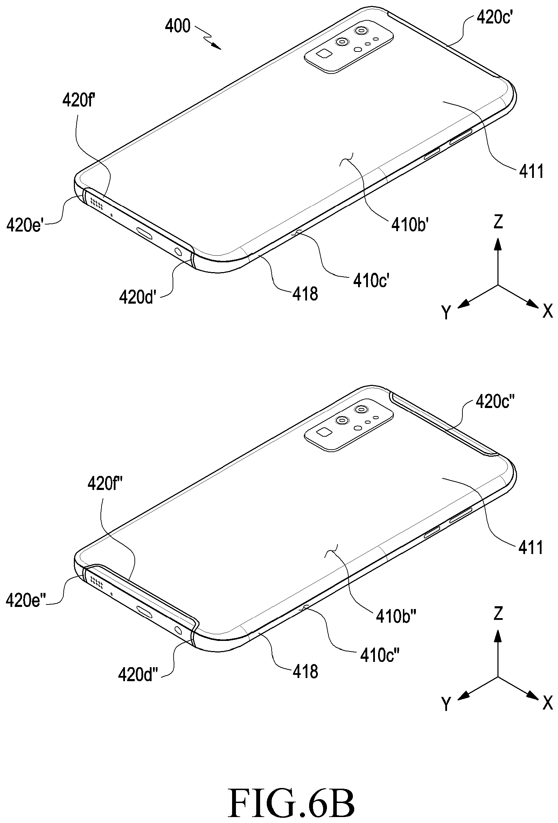

FIG. 5 is views showing the front surface 410a, the side surfaces 410c, and the rear surface 410b of an electronic device 400 according to various embodiments disclosed in the document. FIG. 6a is perspective views showing the front surface 410a and the rear surface 410b of an electronic device (e.g., 400 in FIG. 5) according to another embodiment disclosed in the document. FIG. 6b is perspective views showing the rear surface
(410b' and 410b") of an electronic device (e.g., 400 in FIG. 5) according to various embodiments disclosed in the document.

Referring to FIG. 5, an electronic device 400 (e.g., the electronic device 101 or 300) according to various embodiments disclosed in the document may include a housing 410 including: a front plate 402 (e.g., the front plate 302 or 320); a rear plate 411 (e.g., the rear plate 311 or 380) oriented in a direction opposite to the front plate 402; and a side member 418 (e.g., the side bezel structure 318 or 310) surrounding a space between the front plate 402 and the rear plate 411, and a display 401 (e.g., the display 301 or 330) visually exposed through the front plate 402.

According to various embodiments disclosed in the document, the housing 410 may include a first surface 410a (or a front surface) formed by the front plate 402, a second surface 410b (or a rear surface) formed by the rear plate 411, and third surfaces 410c (or side surfaces) formed by the side member 418. According to an embodiment, the first surface 410a and the second surface 410b may be oriented in different directions, and the third surfaces 410c may be perpendicular to each of the first surface 410a and the second surface 410b.

According to various embodiments disclosed in the document, the third surfaces 410c formed by the side member 418 may have four surfaces corresponding to the shapes of the edge of the rear plate 411, and the four surfaces may be oriented in directions different from each other.

According to various embodiments, at least one of the first surface 410a, the second surface 410b, and the third surfaces 410c may be configured to include a curved-surface.

According to various embodiments, at least one slit 420 may be formed in the side member 418. The at least one slit 420 formed in the side member 418 may be for using at least a portion of the side member 418 as an antenna. In an embodiment, the slits 420 may be formed to isolate and segment at least a portion of the side member 418 from other portions of the side member 418. The number of the slits 420 or the shape of the slit 420 is not limited to any specified embodiment. In addition, the use of the slits 420 may not also be for utilizing at least a portion of the side member 418 as an antenna, but may only be for segmenting the side member 418 into multiple portions.

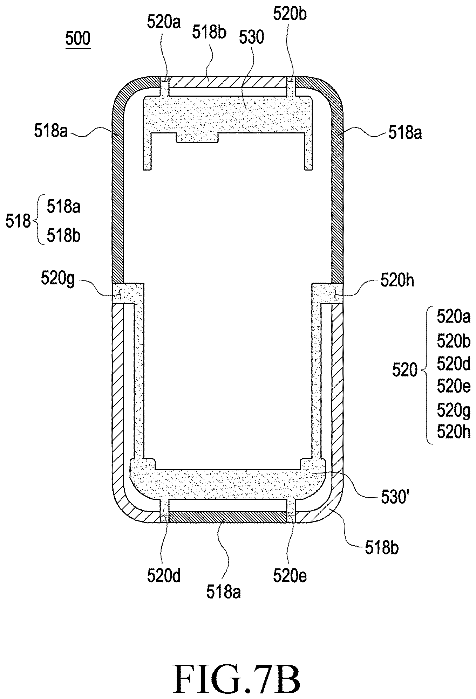

In various embodiments disclosed in the document, the at least one slit 420 may be formed on at least surface of the multiple third surfaces 410c of the side member 418. According to an embodiment, two slits 420 may be formed on any one surface
of the multiple third surfaces 410c of the side member 418. For example, FIG. 5 illustrates that two slits 420a and 420b are formed on the upper side surface of the multiple third surfaces 410c of the side member 418. According to another embodiment, differently from the illustrated embodiment, one slit 420 may be formed on one surface (e.g., the upper surface) of the multiple third surfaces 410c of the side member 418, and one slit 420 may be formed on another one surface (e.g., the right side surface) of the multiple third surfaces 410c of the side member 418, which is adjacent thereto (hereinafter, see the embodiment of FIG. 7B). According to another embodiment, three or more slits 420 may also be formed on any one surface of the multiple third surfaces 410c of the side member 418.

According to various embodiments, in case that the two slits 420a and 420b are formed on one surface (e.g., the upper side surface) of the multiple third surfaces 410c, the two slits 420a and 420b may be spaced apart from each other. According to an embodiment, the two slits 420a and 420b may also be formed symmetrically to each other, based on an imaginary line drawn in the height direction thereof at the center of any one surface (e.g., the upper side surface) of the multiple third surfaces 410c. However, it is not necessarily limited thereto, and the positions at which the slits are formed and the gaps therebetween may be various according to embodiments.

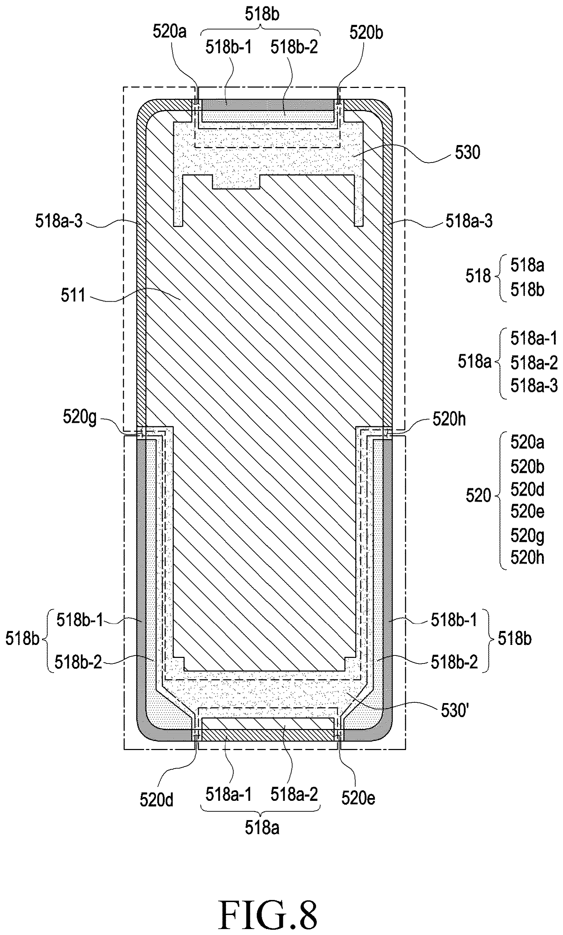

According to various embodiments, the slits 420 may be provided in multiple areas within one electronic device 400. For example, as illustrated in FIG. 5 and FIG. 6A, not only the slits 420a and 420b are formed on the upper side surface, which is one of the multiple surfaces of the side member 418, but also the slits 420d and 420e may be formed on the lower side surface, which is another one of the multiple surfaces of the side member 418. Although FIG. 5 to FIG. 6B illustrate that two slits are provided on each of the upper side surface and the lower side surface of the electronic device, it is not limited thereto. The slits 420 according to various embodiments of the disclosure may also be implemented in the same form or may be implemented in a changed form, on the other surfaces of the multiple third surfaces 410c of the side member 418, which are not mentioned. For example, as the embodiments illustrated in FIG. 7B and FIG. 8 to be described later, the at least one slit 420 may be formed on each of the upper side surface, the lower side surface, the left side surface, and the right side surface of the multiple surfaces of the side member 418. According to various embodiments disclosed in the document, it should be noted that at least one slit may also be additionally or alternatively disposed at a position of the third surfaces 410c, which is not illustrated in the drawings. According to various embodiments, the slits 420 may be variously configured according to the omission or addition of at least one element of a display (e.g., 201), audio modules (e.g., 203, 207, and 214), sensor modules (e.g., 204 and 219), camera modules (e.g., 205, 212, and 213), key input devices (e.g., 215, 216, and 217), an indicator (e.g., 206), or connector holes (208 and 209), and various arrangements of elements.

Referring again to FIG. 5 and FIG. 6A, according to various embodiments disclosed in the document, the slits 420a and 420b or 420d and 420e formed in the side member 418 may be formed to be discrete and spaced apart from each other. Differently therefrom, a portion of the slits 420 may also be formed in the rear plate 411. Referring to FIG. 6B, according to various embodiments disclosed in the document, slits 420c' and 420c" or 420f' and 420f" formed in the rear plate 411 may be formed as one non-discrete slit 420, and slits 420d' and 420e' or 420d" and 420e" formed in the side member 418 may be formed as one non-discrete slit 420. That is, according to various embodiments, the slits 420 may also be formed over the side member 418 and the rear plate 411, and may also have a partially curved-line shape.

Referring to FIG. 6B, according to various embodiments, at least one slit 420c' or 420f', or 420c" or 420f" may be formed in the rear plate 411. According to various embodiments, at least a portion of the slit 420c' or 420f', or 420c" or 420f" formed in the rear plate 411 may also have a predetermined width, and may also extend from one portion to another portion of the rear plate 411. For example, as illustrated in FIG. 6B, at least a portion of the slit 420c' or 420f', or 420c" or 420f" may be formed to be elongated in a direction (e.g., a direction parallel to the x-axis of the spatial coordinate system) parallel to the horizontal side of the rear plate 411 disclosed in the document. According to various embodiments, the slits 420c' and 420f' or 420c" and 420f" formed in the rear plate 411 may also have a continuous shape, but differently therefrom, may have a shape in which a portion thereof is discrete. For example, although the slits 420c' and 420f' or 420c" and 420f" illustrated in FIG. 6B have a continuous shape, but it is not necessarily limited thereto. According to various embodiments, the slits 420c' and 420f' or 420c" and 420f" may also have a separate shape on the rear plate 411, or may also be formed such that the whole or at least a portion thereof is not exposed to the outside of the housing. For example, in case that at least a portion of the rear plate 411 is formed of a material such as glass or synthetic resin, the slits 420c' and 420f' or 420c" and 420f" may have a separate shape, or may be formed such that the whole or at least a portion thereof is not exposed to the outside of the housing.

According to various embodiments, at least a portion of the housing 410 may include an electrically conductive material (e.g., metal). The housing including an electrically conductive material (e.g., metal) may be configured to adjust the shape or dimension (e.g., a length, a height, or an area) thereof so as to variously form the exterior of an electronic device.

According to various embodiments, at least a part of the housing 410 made of an electrically conductive material (e.g., metal) may be isolated through the slits 420. For example, in case that at least a portion of the third surfaces 410c of the side member 418 is formed of a metallic material, the slits 420a and 420b are formed on the corresponding surfaces to electrically segment a portion of the side member 418 from the other parts.

According to various embodiments, an insulating material (e.g., an injection-molded product) may be formed in a segmented portion between one portion and the other portion of the side member 418, which are formed by the slits 420. Hereinafter, an embodiment in which a side member 518 is colored in a state where at least a portion of the insulating material is formed in the segmental portion will be described in detail.

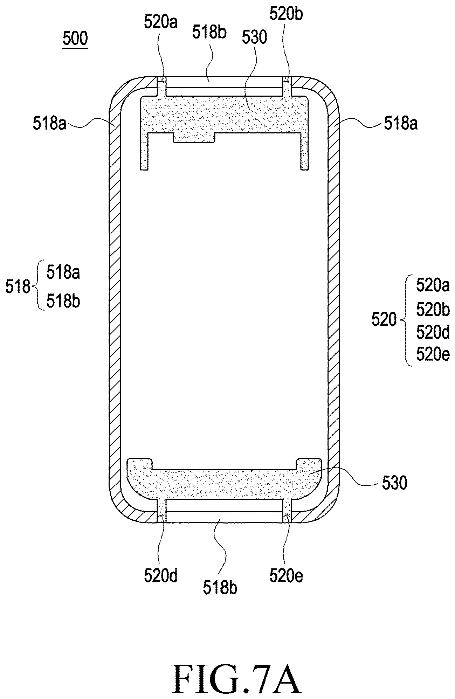

FIG. 7A is a view showing a form in which a first color is applied on a side member 518 including a portion segmented by slits according to an embodiment. FIG. 7B is a view showing a form in which a first color and a second color are colored on a side member 518 including a portion segmented by slits according to an embodiment.

According to various embodiments, slits 520a, 520b, 520d, 520e, 520g, and 520h (e.g., the slits 420a and 420b in FIG. 5) formed on the third surfaces of the side member 518 may divide the side member 518 into two or more substantial parts. For example, in case that the side member 518 is configured by an electrically conductive material (e.g., metal), the side member 518 may be divided into a first portion configured by an electrically conductive material and a second portion which is configured by an electrically conductive material and electrically separated from the first portion.

The housing 500 according to various embodiments disclosed in the document may include insulating materials 530 and 530' for filling the multiple slits formed in the side member 518 and/or the rear plate (e.g., the rear plate 411 in FIGS. 6A or 6B). The insulating materials 530 and 530' may function to limit an electric current flow between some elements and some other elements of an electronic device. For example, in case that the housing 500 of the electronic device is made of an electrically
conductive material (e.g., metal), the insulating materials 530 and 530' may cause an electrical disconnection between some elements and other elements of the housing.

Referring to FIG. 7A, the side member 518 may be divided into portions indicated by reference numeral 518a on the left and the right side surface thereof as a first portion, and portions indicated by reference numeral 518b on the upper and the lower side surface thereof as a second portion. Here, since the arrangement and shape of the first portion and the second portion indicated by reference numerals are merely examples, it should be noted that the arrangement and shape of the first portion and the second portion may be various. According to an embodiment, the first portion 518a and the second portion 518b may be spaced apart by the slits 520a, 520b, 520d, and 520e, and the insulating material (e.g., an injection-molded product) 530 may be disposed in the space between the first portion 518a and the second portion 518b spaced apart from each other so as to electrically insulate the first portion 518a and the second portion 518b.

FIG. 7A illustrates an embodiment in which a first color is applied on the first portion 518a. According to various embodiments of the disclosure, the first portion 518a may include multiple first portions 518a (e.g., the first portions 518a respectively arranged at the left and the right side surface of the side member 518 in FIG. 7A), which are physically spaced apart from each other, and the first portions may be simultaneously colored through an anodizing process. The second portion (or the second portions) may be electrically insulated from the first portions by an insulating material 530, and thus may not be colored during the anodizing process for coloring the first portions.

The side member 518 according to the embodiment illustrated in FIG. 7B may be divided into portions indicated by reference numeral 518a on the left upper end, the right upper end, and the lower end thereof as a first portion, and portions indicated by reference numeral 518b on the left lower end, the right lower end, and the upper end thereof as a second portion. Here, the first portions 518a and the second portions 518b may be spaced apart by the slits 520a, 520b 520d, 520e, 520g, and 520h, and the insulating materials (e.g., an injection-molded product) 530 and 530' may be arranged in the space between the first portions 518a and the second portions 518b spaced apart from each other so as to electrically insulate the first portions 518a and the second portions 518b. As illustrated in FIG. 7A and FIG. 7B, the arrangement and shape of the insulating materials 530 and 530' are not limited to any specific embodiment. In addition to the embodiment illustrated in FIG. 7B, a slit may be additionally formed on the third surfaces of the side member 518, and thus the side member 518 may have a greater number of segmented pieces.

FIG. 7B illustrates an embodiment in which a first color is applied on the first portions 518a and a second color is applied on the second portions 518b. The first portions 518a may include multiple first portions 518a (e.g., the first portions 518a respectively arranged at the left upper end, the right upper end, and the lower end of the side member 518 in FIG. 7B), which are physically spaced apart from each other, and the first portions may be simultaneously colored through an anodizing process. In addition, the second portion 518b may include multiple second portions 518b (e.g., the second portions 518b respectively arranged at the upper end, the right lower end, and the left lower end of the side member 518 in FIG. 7B), which are physically spaced apart from each other, and the second portions may be simultaneously colored through an anodizing process. According to various embodiments of the disclosure, the anodizing process for the first portions and the anodizing process for the second portions may be performed continuously, and since the first portions and second portions are electrically insulated, there may be an advantage of omitting steps such as processing or cleaning performed between the anodizing processes continuously performed. In this regard, it will be described later in detail.

FIG. 8 is a view showing a housing 500 having multiple segmented pieces according to various embodiments disclosed in the document.

Differently from the embodiments illustrated in FIG. 7A and FIG. 7B, in which only the side member 518 is colored, FIG. 8 illustrates an embodiment in which the side member 518 and the support member 511 are colored with a designated color. In addition, differently from the embodiments illustrated in FIG. 7A and FIG. 7B, FIG. 8 illustrates an embodiment in which not only an outer wall 518a-1 or 518b-1 of the side member 518 but also an inner wall 518a-2 or 518b-2 of the side member 518 are colored with a designated color.

According to various embodiments of the disclosure, the housing 500 not only may include a front plate (e.g., the front plate 402 in FIG. 5), a rear plate (e.g., the rear plate 411 in FIG. 5), and a side member (e.g., the side member 418 in FIG. 5) described above in FIG. 5 but also may be a configuration including a support member 511 (e.g., the support members 332 and 360 in FIG. 4) disposed in the inner space of the housing as illustrated in FIG. 8.

The housing 500 may include an electrically conductive material, and may be divided into two or more substantial parts each of which includes an electrically
conductive material. According to an embodiment, as previously described in the embodiments of FIG. 5 and FIG. 6A, the side member 518 included in the housing 500 may be divided into two or more substantial parts. Alternatively, as previously described in the embodiment of FIG. 6B, a combination configuration of the side member 518 and the rear plate 411 included in the housing 500 may be divided into two or more substantial parts. Alternatively, a combination configuration of the side member 518 and the support member 511 included in the housing 500 may be divided into two or more substantial parts.

According to various embodiments, although the side member 518 and/or the rear plate 411 included in the housing 500 is described as a portion of the electronic device, it is not limited thereto, and the side member and/or the rear plate may be implemented as a structure attachable to or detachable from the housing 500 of the electronic device. For example, the side member 518 and/or the rear plate 411 may be coupled to the electronic device so as to protect the electronic device from external impacts or foreign substances. According to various embodiments, the housing 500 may be referred to as various terms such as "a cover", "a case", "an envelope", "an exterior case", "an accessory case", or "an enclosure". According to various embodiments, the side member 518 and/or the rear plate 411 included in the housing 500 is not limited to the embodiment mentioned in the document, and may be molded into various shapes according to the shape of the electronic device.

FIG. 8 illustrates an embodiment in which the combination of the side member 518 and the support member plate 511 included in the housing 500 is divided into two or more substantial parts. The side member 518 and the support member 511 may be configured by an electrically conductive material (e.g., metal). For example, the combination configuration of the side member 518 and the support member 511 may include a first portion configured by an electrically conductive material, and a second portion which is configured by an electrically conductive material and electrically separated from the first portion. That is, in the embodiment of FIG. 8, the housing 500 may include a first portion and a second portion as two substantial parts.

According to the embodiment illustrated in FIG. 8, the first portion may include a portion indicated by reference numeral 518a in the side member 518, and a support member 511. The second portion may include a portion indicated by reference numeral 518b in the side member 518. Here, the first portion may be included in an area indicated by the dotted line in the housing, and the second portion may be included in an area indicated by the alternate long and short dash line in the housing.
In one housing 500, the first portion and the second portion may include multiple first portions and multiple second portions, respectively. Here, the first portions 518a and 511 and the second portions 518b may be spaced apart from each other by the slits 520a, 520b, 520d, 520e, 520g, and 520h, and the insulating materials (e.g., an injection-molded product) 530 and 530' may be formed in the space formed by being spaced therebetween so as to electrically insulate the first portions 518a and 511 and the second portions 518b. However, the above-described example may be merely an embodiment, and thus is not necessarily limited thereto. The second portion may also be configured to include one portion of the side member 518 and at least one portion of the support member 511.

According to the embodiment illustrated in FIG. 8, a substantial part of the housing 500 may be divided into a first portions 518a and 511 and a second portions 518b, and at least some of the first portions 518a and 511 and the second portions 518b may include an outer wall facing the outside of the housing and an inner wall oriented in a direction opposite to the outer wall. For example, the side member 518 may include a first portion 518a including a first outer wall 518a-1 and a first inner wall 518a-2, and a second portion 518b including a second outer wall 518b-1 and a second inner wall 518b-2. For one example, some of the first portions 518a and 511 may include the first outer wall 518a-1 and the first inner wall 518a-2, but others of the first portions 518a and 511 may also include a third outer wall 518-3 and a support member 511. Here, the support member 511 may be configured to include an inner wall oriented in a direction opposite to the third outer wall 518-3.

Substantial parts of the housing 500 may include multiple areas which are two or more areas electrically separated. In this case, each of the areas may be implemented with different colors. However, in case that "anodizing", which is a surface treatment method to be described later, is performed, an electric current may flow between the outer wall and the inner wall of the same segmented area (e.g., the first portion or the second portion), and thus the outer wall and the inner wall of the same segmented area (e.g., the first portion or the second portion) may be colored with the same series of colors. For example, the first outer wall 518a-1 and the first inner wall 518a-2 of the first portions 518a and 511 may also be formed to have the same first color series, the third outer wall 518-3 and the support member 511 may also be formed to have the same first color series, and the second outer wall 518b-1 and the second inner wall 518b-2 of the second portion 518b may also be formed to have the same second color series. More specifically, in case that the first outer wall 518a-1 in
the first portion 518a is colored with "RED color", the first inner wall 518a-2, which is the same segmented area, may also be colored with "RED color", in case that the second outer wall 518b-1 in the second portion 518b is colored with "BLUE color", the second inner wall 518b-2, which is the same segmented area, may also be colored with "BLUE color", and thus multiple colors may be implemented. However, this may be merely an example, and color implementation is not necessarily limited thereto. That is, as the outer wall of the housing is implemented with multiple colors, the inner wall of the housing may also have a feature of being divided into multiple colors. According to an embodiment, the outer wall and the inner wall of the same segmented area (e.g., the first portion or the second portion) may have a difference in color according to a surface state (e.g., roughness or gloss) for each area or a posttreatment process. For example, in the first portions 518a and 511, the first outer wall 518a-1 may include "deep RED color", the first inner wall 518a-2, which is the same segmented area, may include "light RED color", and thus the same series of different colors may be included therein. For one example, in the first portions 518a and 511, the wall 518a-3 may include "deep RED color", the support member 511, which is the same segmented area, may include "light RED color", and thus the same series of different colors may be included therein. For one example, in the second portions 518b, the second outer wall 518b-1 may include "deep BLUE color", the second inner wall 518b-2, which is the same segmented area, may include "light BLUE color", and thus the same series of different colors may be included therein. In various embodiments of the disclosure, the first outer wall 518a-1, the wall 518a-3, the second inner wall 518a-2, the third inner wall 518a-3, and the support member 511 of the first portions 518a and 511 may be colored with the same series of colors through a primary anodizing process, and the second outer wall 518b-1 and the second inner wall 518b-2 of the second portion 518b may be colored with the same series of colors through a secondary anodizing process continuously performed following the primary anodizing process. According to various embodiments of the disclosure, in order to enhance the aesthetic beauty of the exterior thereof, the outer wall may be colored with various colors, and furthermore, the inner wall may also be colored with various colors.

In summary, in various embodiments of the disclosure, the outer wall (e.g., the first outer wall 518a-1 and third outer wall 518a-3) of the first portions 518a and 511 may be formed to have a (1-1)th color, the inner wall (e.g., the first inner wall 518a-2 and/or the support member 511) of the first portions 518a and 511 may be formed to have a (1-2)th color, the outer wall (e.g., the second outer wall 518b-1) of the second
portion 518b may be formed to have a (2-1)th color, and the inner wall (e.g., the second inner wall 518b-2) of the second portion 518b may be formed to have a (2-2)th color. According to an embodiment, the (1-1)th color and the (1-2)th color may be the same series of first colors, and the (2-1)th color and the (2-2)th color may also be the same series of second colors. According to an embodiment, the (1-1)th color and the (1-2)th color may be formed as the same series of the first colors through a primary anodizing process, and the (2-1)th color and the (2-2)th color may be formed as the same series of the second colors through a secondary anodizing process. However, various embodiments of the disclosure are not limited thereto. The (1-1)th color, the (1-2)th color, the (2-1)th color, and the (2-2)th color may also be different colors according a surface state (e.g., roughness or gloss) for each area or a posttreatment process. For example, the (1-1)th color, the (1-2)th color, the (2-1)th color, and the (2-2)th color may be four colors different from each other through total four anodizing processes. In addition, other various embodiments may be applied.

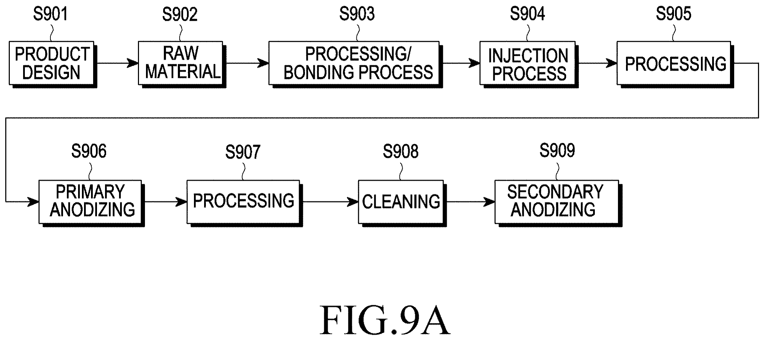

Hereinafter, a housing structure manufacturing method including an anodizing method will be described in detail with reference to FIG. 9A to FIG. 13.

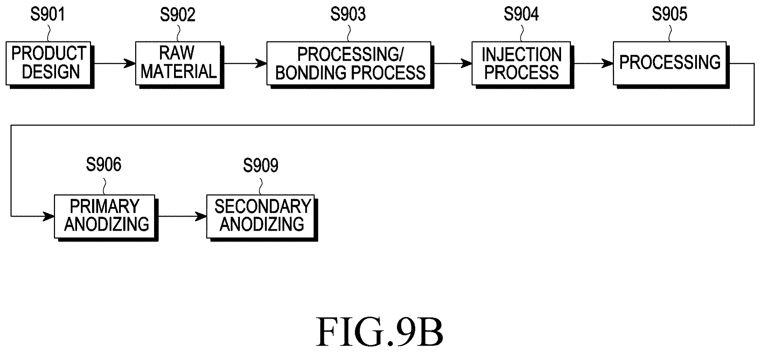

FIG. 9A is a flowchart showing a housing structure manufacturing method including an anodizing method according to some embodiments. FIG. 9B is a flowchart showing a housing structure manufacturing method including an anodizing method according to various embodiments of the disclosure.

First, in operation S901, design is performed to determine the appearance and shape of a product to be produced. After determining the design of the exterior to be implemented, the number of colors to be expressed on the exterior, and specific colors and locations at which the colors are to be arranged, a section in which a synthetic resin (e.g., resin) and an electrically conductive material (e.g., metal) (hereinafter, "a metal member") are to be arranged, may be selected.

Next, in operation S903, a raw material for the housing, which includes a metal member, may be provided. For example, an aluminum plate material used as an exterior material or an interior material of electronic device may be used as the raw material of the housing. For example, the aluminum plate material may include from a 2xxx-series alloy to a 6xxx-series alloy, and/or a 7xxx-series alloy having high strength, except for pure aluminum. For example, an aluminum alloy material may include aluminum as a main component thereof, and may include copper, magnesium, manganese, silicon, tin, or zinc as a main alloying element thereof. Next, in operation S903, a cutting processing and bonding process of the raw material of the housing,
which includes the metal member, may be performed. The housing may be manufactured in a desired shape through the cutting processing process. A member, which has been subject to the cutting processing process, is subjected to the bonding process, and here, the bonding process may mean all chemical and physical treatment processes which allow a metal and a molten resin injected in an injection process to be bonded to each other. Since a metal, to which a bonding treatment is not applied, is broken or spaced apart due to an insufficient bonding property with an injection resin, the bonding process may have to be done before an injection process.

Next, in operation S904, a molten resin may be injected into the metal member through an injection process so as to bond the resin and the metal.

In operation S905, a member, which has been subjected to the injection process, may be processed into a desired final shape through a processing process. Here, the processing process may include both a polishing (wet and dry polishing) process and Dia-Cut processing which may be involved in the final appearance of the exterior material, in addition to a simple cutting process. According to an embodiment, the polishing process may be performed to implement high gloss on the surface of the metal member to be applied to the electronic device, and the polishing process may include a physical polishing (dry/wet polishing) process and/or an electro polishing process. In the polishing process, an electro polishing process may be performed after a physical polishing process is performed. As another example, a physical polishing process may be performed after an electro polishing process is performed. As another example, a physical polishing process and an electro polishing process may be selectively performed. For example, physical polishing may be performed by touching a rotating polishing device onto the surface of the metal member. The physical polishing process may be selectively used among wet polishing in which the surface of the metal member is polished in a wet state and dry polishing in which the surface of the metal member is polished in a dry state. The electro polishing process may use an anodic dissolution phenomenon to smooth and/or polish the surface of the metal member. According to various embodiments, after the polishing process (for example, the physical polishing process and/or the electro polishing process) is performed, a surface curve forming process may be performed. The surface curve forming process may be performed after a physical polishing process is performed or after an electro polishing process is performed. As another example, the surface curve forming process may also be performed after a physical polishing process and an electrolytic process are sequentially performed, or may also be performed in a state where the polishing process is not performed. According to various embodiments, the surface curve forming process may be performed in order to implement a curve (e.g., roughness) on the surface of the metal member to be applied to the electronic device, and may include a method of physically applying force such as sandblasting, and/or a method of chemically applying force such as chemical etching. In addition, the processing process may include all the processes, such as barrel polishing, sand blasting, and hairline, which are involved in an appearance thereof.

In operation S906 and operation S909, an anodizing process may be performed. In detail, the anodizing process may include a pretreatment step (cleaning), an anode oxide film formation step (or an anodizing step), a dyeing step, and/or a posttreatment step (or a sealing step). The pretreatment step may include a degreasing process, a chemical polishing process, and a de-smut process. In this case, in the degreasing process, an acidic or a neutral degreasing solution may be selectively applied according to a process environment and a target material. The chemical polishing process may be performed to flatten an uneven surface of a material, which is non-uniformly treated, so as to reduce diffuse reflection and improve surface gloss thereof. The de-smut process may be performed to remove smut and foreign substances on the surface of a material, which have been generated during the degreasing process and the chemical polishing process. Next, the surface of a metal exterior material may be anodized. The anode oxide film formation step may be performed in a state of putting the housing including the metal member in a container in which at least one electrolyte among sulfuric acid, oxalic acid, phosphoric acid, chromic acid, organic acid (citric acid, acetic acid, propionic acid, tartaric acid), or boric acid, or an electrolyte including all thereof is received, and applying a predetermined voltage and temperature thereto. In the anode oxide film formation step, since a voltage is applied to the metal member, the metal member may react with oxygen so that an oxide film having high density is formed. For example, a working voltage within the range of about 5 - 20V may be applicable, and the process time may take about 10 minutes to 3 hours. The process temperature within the entire range of about 5 - 30 °C may be applicable. After the anodizing step, a dyeing process may be performed. The dyeing process may be a process of expressing color on the anodized oxide film. For example, there are an immersion method, an electrolytic dyeing method, or an oil-based method as the types of dyeing process. The immersion method is a method of immersing a product into a solution in which a dye is dissolved such that the dye is diffused and adsorbed into the product in order to implement a color, and the electrolytic dyeing method is a method of applying an electric current in a metal salt electrolyte or the like to express a color. The oil-based method is a dyeing method of photosensitizing and drying an oxide film, and then coloring same with an oil-based dye by using a brush. Here, a dye used in an immersion method may include both an organic dye and an inorganic dye, and an immersion method may also be called as an aqueous method since the dyes used in an immersion method are mainly soluble in water. Next, in the posttreatment step, a film sealing treatment and a post-sealing treatment may be performed. The sealing treatment may include both a treatment method using metal salts and a treatment method using non-metal salts made of an organic matter. A hydration sealing treatment using water and steam may be included therein. The post-sealing treatment may include an elution process for removing metal salts or a hot water cleaning process for cleaning foreign substances. The posttreatment steps may be performed to secure the exterior stability and reliability of the anodized and colored material.

According to the embodiment illustrated in FIG. 9A, between the two anodizing processes according to operation S906 and operation S909, a processing step S907 and a cleaning step S908 may be performed. The processing step S907 may be a step of, when the color according to the anodizing process of operation S906 is colored thereon, cutting and processing same, or of polishing the oxide film generated in the anodizing step to remove the primary anodized film, in a section where different color coloring is required. A cleaning step S908 may be a step of removing processing by-products (e.g., cutting oils, processing burrs, and other foreign substances) generated in the processing step S907 to clean a surface on which the process of a secondary anodizing S907 is to be performed.

According to various embodiments of the disclosure illustrated in FIG. 9B, between the two anodizing processes according to operation S906 and operation S909, the processing step S907 and the cleaning step S908 may be omitted. That is, the primary anodizing process S906 and the secondary anodizing process S909 may be continuously performed without the intermediate processing step and the cleaning step. Accordingly, multi-coloring is possible even having a reduced number of processes so that the cost is saved and the productivity thereof is improved. According to various embodiments of the disclosure, a continuous anodizing process may be a process of continuously performing anodizing processes as many as the number of colors required to be implemented. The continuous anodizing process may include not only the primary and the secondary anodizing but also a tertiary anodizing process or more anodizing processes.

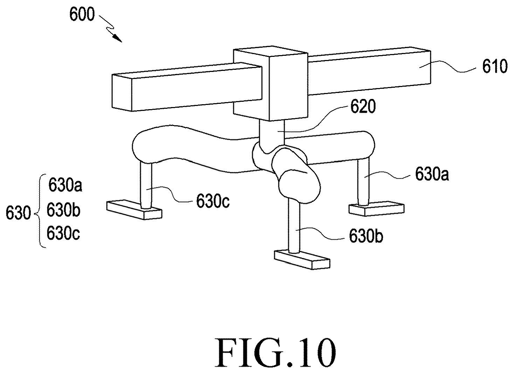

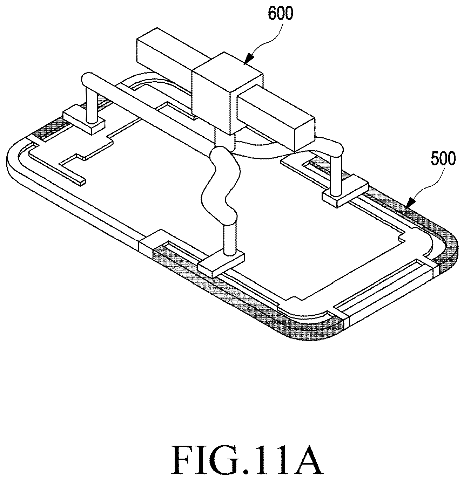

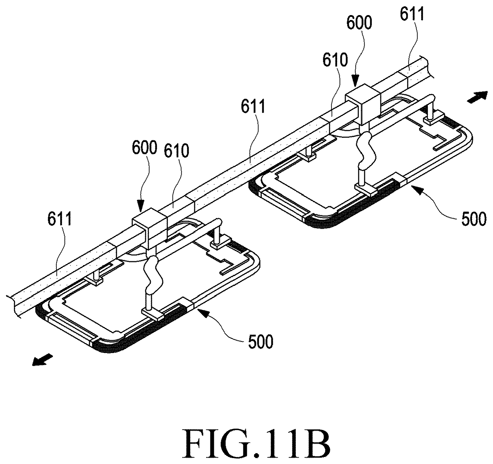

FIG. 10 is a view showing a jig used for performing an anodizing process according to various embodiments of the disclosure. FIG. 11A is a view showing a form in which a jig is mounted to a housing 500 according to various embodiments of the disclosure. FIG. 11B is a view showing a use aspect of a jig used for performing an anodizing process according to various embodiments of the disclosure.

A jig 600 may be provided to allow an electric current to flow through a metal member so as to generate an oxide film on the surface of the metal member. In case that anodizing is performed, an oxide film may be generated only on the surface of a metal member, to which the jig 600 is connected and thus through which an electric current flows, and an oxide film may not be formed on a metal member separated by an insulating material. In a dyeing step after the oxide film is formed, only the surface of a metal member, to which the jig 600 is connected, may be colored.

The jig 600 used here may include jigs which are made of metal materials allowing an electric current flow and have shapes allowing the jig 600 to be stably mounted to a product, in an anodizing process. For example, FIG. 10 illustrates the jig 600 including a shaft 620, a connection member 610 provided at one end of the shaft 620, and multiple branches 630a, 630b, and 630c formed at the other end of the shaft 620. Although the drawings illustrate a jig having three branches, it is not limited thereto. The type of the jig may be various according to embodiments. The jig may also be a jig capable of being inserted into a through-hole formed through the housing, a jig brought into close contact with the surface of the housing so as to press the housing, or a jig caught on and fixed to a concave/convex part formed on the housing.

Referring to FIG. 11A, in case that different colors are additionally colored to implement multiple colors, the jig may be connected to the surface of a metal member, which is not anodized, by changing a position to which the jig 600 is mounted, that is, a position in which the jig 600 is supported by the housing 500, and thus additional anodizing and coloring processes may be performed.

Referring to FIG. 11B, the jig 600 may perform a series of anodizing processes together with another jig 600 by using the connection member 610. For example, the connection member 610 of each jig 600 may be connected and mounted to a rod part 611 for transporting the jig 600 in one or the other direction. According to various embodiments, the connection member 610 may also be formed integrally with the rod part 611. An anodizing method of the disclosure may be applied to multiple housings 500 through the jig 600.

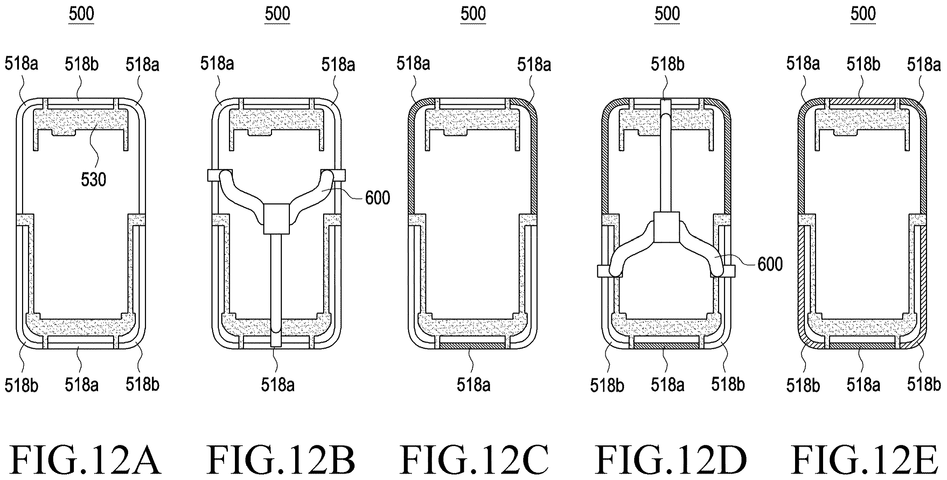

FIGS. 12a to 12e are views showing implemented examples by a continuous anodizing process according to various embodiments of the disclosure.

According to various embodiments of the disclosure, the branch of the jig 600 may be selectively connected only to a designated electrically conductive material portion of areas divided into an electrically conductive material and an insulating material such that the designated electrically conductive material portion is anodized and colored. For example, as illustrated in FIGS. 12A to FIG. 12C, in the primary anodizing process, the jig 600 may be connected to the first portions 518a and 511 of the side member 518. As a result of the primary anodizing process, only the surface of the metal member, to which the jig 600 is connected, may be colored with a designated color. In order to perform additional coloring, as illustrated in FIGS. 12D to 12E, the jig 600 may be connected to the second portion 518b, which is not anodized, so as to perform the secondary anodizing process and coloring process. In this way, a desired color may be variously implemented for each section through the anodizing processes continuously performed. In this way, multi-layered colors may be implemented by repeating the anodizing processes as many as desired colors.

Referring to FIG. 12, it is illustrated that the three branches of the jig 600 are connected to the first portions 518a and 511 and the second portion 518b of the side member 518. However, it is not necessarily limited thereto. For example, in case that the support member 511 of the first portions 518a and 511 and the first portion 518a of the first portions 518a and 511, which is positioned at the lower end of the housing 510, are connected to an electrically conductive material (not shown) (e.g., aluminum) included in an injection molded product, and thus form a single electrical conductor, the anodizing and coloring process may be performed using the jig 600 including two branches.

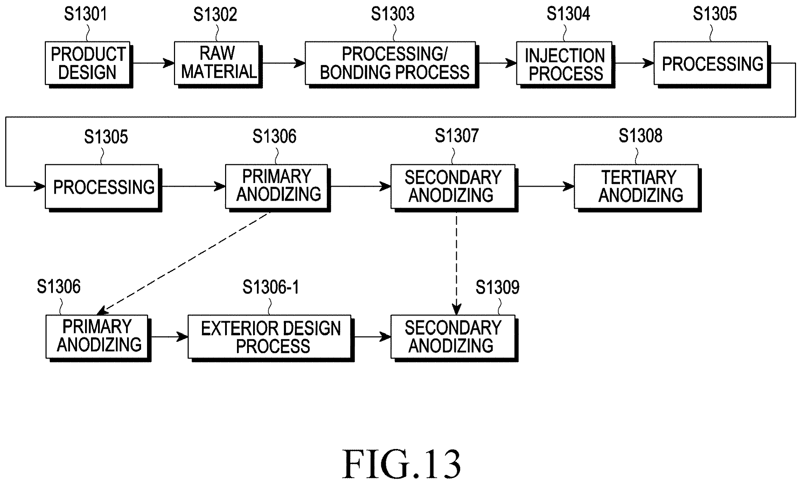

FIG. 13 is a view showing an application example of a continuous anodizing process according to various embodiments of the disclosure.

According to various embodiments, through a continuous anodizing process, the color of the divided metal member (e.g., a first portion and a second portion) may be implemented according to a desired design, and various textures as well as various colors may be implemented for each of sections segmented by the slits. For example, barrel polishing, wet/dry polishing, blasting, or hairline processes, which are involved in the appearance thereof, may be performed between the continuously performed anodizing processes, so that different textures for the segmented sections of a metal member are implemented. Even in case the same processes are applied to one product,
different textures may be implemented for the segmented sections of the metal member because the effects, which are implemented on a surface to which anodizing is applied and a surface to which anodizing is not applied, are different.

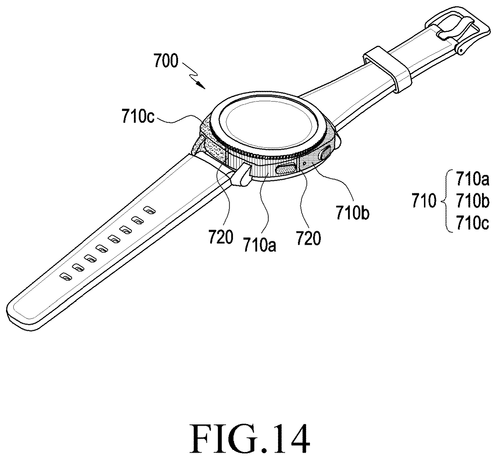

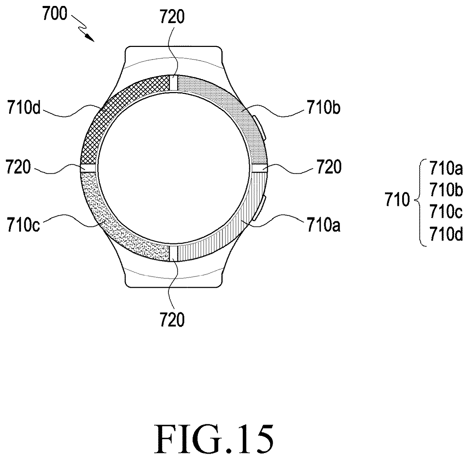

FIG. 14 is a perspective view showing a wearable electronic device 700 having a housing, the exterior of which are colored by various colors in a continuous anodizing method. FIG. 15 is a front view showing a wearable electronic device in which various colors are implemented on the exterior of a housing by using a continuous anodizing method.

The housing and the housing manufacturing method according to various embodiments of the disclosure may be applicable to all product groups using metal as an exterior material thereof in addition to the outer frame of the portable terminals illustrated in FIG. 2 to FIG. 13.

For example, as illustrated in FIG. 14, a wearable electronic device 700 may be formed to have an insulating material at a segmented portion which is between one portion and the other portion of the side member and is formed by at least one slit 720. The at least one slit 710 may divide the housing (e.g., a side member) into two or more substantial parts. For example, in case that the housing of the wearable electronic device is made of an electrically conductive material (e.g., metal), an insulating material may be used to cause an electrical disconnection between some elements and other elements of the housing. The two or more electrically insulated substantial parts may be implemented to have various colors by using a continuous anodizing method.

For example, according to the embodiments illustrated in FIG. 14 and FIG. 15, a housing 710 (e.g., a side member) may be divided into a first portion 710a, a second portion 720b, a third portion 720c, and a fourth portion 720d as four substantial parts. According to an embodiment, the first portion 710a, the second portion 720b, the third portion 720c, and the fourth portion 720d may be implemented to have different colors, and in order to implement the housing 710, the housing structure manufacturing method including the anodizing method described above in FIG. 13 and FIG. 14 may be applied thereto.

## Claims

1. A housing (500) for an electronic device (101), the housing (500) comprising
a front plate (302); a rear plate (311) facing in a direction opposite to the front plate (302); a side member (518) surrounding a space between the front plate (302) and the rear plate (311); and a support member (332) disposed in the space, wherein
the side member (518) of the housing (500) is formed of an electrically conductive material and the side member (518) is divided into a first portion (518a) and a second portion (518b) electrically separated from the first portion (518a),
wherein the first portion (518a) and the second portion (518b) are spaced apart by slits (520a, 520b, 520d, 520e) formed in the side member (518), and the housing (500) includes an insulating material (530) filling the slits (520a, 520b, 520d, 520e), and **characterized in that**
the first portion (518a) includes a first oxide film formed through a primary anodizing and the first oxide film is colored with a first color, and the second portion (518b) includes a second oxide film formed through a secondary anodizing and the second oxide film is colored with a second color different from the first color.

2. The housing (500) of claim 1, wherein the side member (518) of the housing (500) forms side surface of the housing (500).

3. The housing (500) of claim 1, wherein each of the first portion (518a) and the second portion (518b) comprises an outer wall facing the outside of the housing (500) and an inner wall facing in a direction opposite to the outer wall.

4. The housing (500) of claim 3, wherein the outer wall of the first portion (518a) has a first color of first color series, the inner wall of the first portion (518a) has a second color of the first color series, the outer wall of the second portion (518b) has a first color of second color series, and the inner wall of the second portion (518b) has a second color of a second color series.

5. The housing (500) of claim 3, wherein the outer wall and the inner wall of the first portion (518a) are colored by same color series according to the primary anodizing, and the outer wall and inner wall of the second portion (518b) are colored by same color series according to the secondary anodizing which is continuously performed following the primary anodizing.

6. The housing (500) of claim 1, wherein the first portion (518a) comprises multiple first parts physically spaced apart from each other.

7. The housing (500) of claim 1, wherein the second portion (518b) comprises multiple second parts physically spaced apart from each other.

8. An electronic device (101) comprising the housing of any preceding claim.

9. A method of manufacturing the housing (500) of any one of claims 1 to 7, the method comprising:
processing the housing which includes the side member (518);
primary anodizing to form a predetermined oxide film on the first portion (518a) of the side member (518);
primary coloring the oxide film formed on the first portion (518a) by using a colorant having the first color;
secondary anodizing to form a predetermined oxide film on the second portion (518b) of the side member (518b); and
secondary coloring the oxide film formed on the second portion (518b) by using a colorant having the second color,
wherein the first portion (518a) and the second portion (518b) are spaced apart by slits (520a, 520b, 520d, 520e) formed in the side member (518), and the housing (500) includes an insulating material (530) filling the slits (520a, 520b, 520d, 520e).

10. The housing manufacturing method of claim 9, further comprising pre-treating the surface of the side member (518) to have predetermined glossiness and flatness before the primary anodizing.

11. The housing manufacturing method of claim 9, further comprising sealing to maintain the performance and properties of the colorants on the oxide films, which are colored, after the primary anodizing and the secondary anodizing.

12. The housing manufacturing method of claim 9, wherein the side member (518) comprises an aluminum alloy.

## Patentansprüche

1. Gehäuse (500) für eine elektronische Vorrichtung (101), wobei das Gehäuse (500) Folgendes umfasst
eine Frontplatte (302); eine Rückplatte (311), die in eine Richtung zeigt, die entgegengesetzt der Frontplatte (302) ist; ein Seitenelement (518), das einen Raum zwischen der Frontplatte (302) und der Rückplatte (311) umgibt; und ein Stützelement (332), das in dem Raum angeordnet ist, wobei
das Seitenelement (518) des Gehäuses (500) aus einem elektrisch leitenden Material ausgebildet ist und das Seitenelement (518) in einen ersten Abschnitt (518a) und einen zweiten Abschnitt (518b) geteilt ist, der elektrisch von dem ersten Abschnitt (518a) getrennt ist,
wobei der erste Abschnitt (518a) und der zweite Abschnitt (518b) durch in dem Seitenelement (518) ausgebildete Schlitze (520a, 520b, 520d, 520e) voneinander beabstandet sind und das Gehäuse (500) ein die Schlitze (520a, 520b, 520d, 520e) füllendes Isoliermaterial (530) enthält, und **dadurch gekennzeichnet, dass**
der erste Abschnitt (518a) einen ersten Oxidfilm enthält, der durch ein primäres Anodisieren ausgebildet ist, und der erste Oxidfilm mit einer ersten Farbe gefärbt ist, und der zweite Abschnitt (518b) einen zweiten Oxidfilm enthält, der durch ein sekundäres Anodisieren ausgebildet ist, und der zweite Oxidfilm mit einer zweiten Farbe gefärbt ist, die sich von der ersten Farbe unterscheidet.

2. Gehäuse (500) nach Anspruch 1, wobei das Seitenelement (518) des Gehäuses (500) eine Seitenoberfläche des Gehäuses (500) ausbildet.

3. Gehäuse (500) nach Anspruch 1, wobei jeder von dem ersten Abschnitt (518a) und dem zweiten Abschnitt (518b) eine Außenwand, die zu der Außenseite des Gehäuses (500) zeigt, und eine Innenwand, die in eine Richtung, die entgegengesetzt zu der Außenwand ist, zeigt, umfasst.

4. Gehäuse (500) nach Anspruch 3, wobei die Außenwand des ersten Abschnitts (518a) eine erste Farbe einer ersten Farbreihe aufweist, die Innenwand des ersten Abschnitts (518a) eine zweite Farbe der ersten Farbreihe aufweist, die Außenwand des zweiten Abschnitts (518b) eine erste Farbe einer zweiten Farbreihe aufweist und die Innenwand des zweiten Abschnitts (518b) eine zweite Farbe einer zweiten Farbreihe aufweist.

5. Gehäuse (500) nach Anspruch 3, wobei die Außenwand und die Innenwand des ersten Abschnitts (518a) durch eine gleiche Farbreihe gemäß dem primären Anodisieren gefärbt sind und die Außenwand und die Innenwand des zweiten Abschnitts (518b) durch eine gleiche Farbreihe gemäß dem sekundären Anodisieren, das kontinuierlich nach dem primären Anodisieren durchgeführt wird, gefärbt sind.

6. Gehäuse (500) nach Anspruch 1, wobei der erste Abschnitt (518a) mehrere erste Teile umfasst, die physisch voneinander beabstandet sind.

7. Gehäuse (500) nach Anspruch 1, wobei der zweite Abschnitt (518b) mehrere zweite Teile umfasst, die physisch voneinander beabstandet sind.

8. Elektronische Vorrichtung (101), umfassend das Gehäuse nach einem vorhergehenden Anspruch.

9. Verfahren zum Herstellen des Gehäuses (500) nach einem der Ansprüche 1 bis 7, wobei das Verfahren Folgendes umfasst:
Fertigen des Gehäuses, das das Seitenelement (518) enthält;
primäres Anodisieren, um einen vorbestimmten Oxidfilm auf dem ersten Abschnitt (518a) des Seitenelements (518) auszubilden;
primäres Färben des Oxidfilms, der auf dem ersten Abschnitt (518a) ausgebildet ist, durch Verwenden eines Farbstoffs mit der ersten Farbe;
sekundäres Anodisieren, um einen vorbestimmten Oxidfilm auf dem zweiten Abschnitt (518b) des Seitenelements (518b) auszubilden; und
sekundäres Färben des Oxidfilms, der auf dem zweiten Abschnitt (518b) ausgebildet ist, durch Verwenden eines Farbstoffs mit der zweiten Farbe,
wobei der erste Abschnitt (518a) und der zweite Abschnitt (518b) durch in dem Seitenelement (518) ausgebildete Schlitze (520a, 520b, 520d, 520e) voneinander beabstandet sind und das Gehäuse (500) ein die Schlitze (520a, 520b, 520d, 520e) füllendes Isoliermaterial (530) enthält.

10. Gehäuseherstellungsverfahren nach Anspruch 9, ferner umfassend Vorbehandeln der Oberfläche des Seitenelements (518), sodass sie vor dem primären Anodisieren eine vorbestimmte Glätte und Ebenheit aufweist.

11. Gehäuseherstellungsverfahren nach Anspruch 9, ferner umfassend Abdichten, um die Leistung und die Eigenschaften der Farbstoffe auf den Oxidfilmen, die gefärbt sind, nach dem primären Anodisieren und dem sekundären Anodisieren aufrechtzuerhalten.

12. Gehäuseherstellungsverfahren nach Anspruch 9, wobei das Seitenelement (518) eine Aluminiumlegierung umfasst.

## Revendications

1. Boîtier (500) pour un dispositif électronique (101), le boîtier (500) comprenant
une plaque avant (302) ; une plaque arrière (311) orientée dans une direction opposée à la plaque avant (302) ; un élément latéral (518) entourant un espace entre la plaque avant (302) et la plaque arrière (311) ; et un élément de support (332) disposé dans l'espace,
ledit élément latéral (518) du boîtier (500) étant formé d'un matériau électriquement conducteur et ledit élément latéral (518) étant divisé en une première section (518a) et une seconde section (518b) électriquement séparée de la première section (518a),
ladite première section (518a) et ladite seconde section (518b) étant espacées par des fentes (520a, 520b, 520d, 520e) formées dans l'élément latéral (518), et ledit boîtier (500) comprenant un matériau isolant (530) remplissant les fentes (520a, 520b, 520d, 520e), et **caractérisé en ce que**
la première section (518a) comprend un premier film d'oxyde formé par une anodisation primaire et le premier film d'oxyde est coloré d'une première couleur, et la seconde section (518b) comprend un second film d'oxyde formé par une anodisation secondaire et le second film d'oxyde est coloré d'une seconde couleur différente de la première couleur.

2. Boîtier (500) de la revendication 1, ledit élément latéral (518) du boîtier (500) formant une surface latérale du boîtier (500).

3. Boîtier (500) de la revendication 1, chacune de la première section (518a) et de la seconde section (518b) comprenant une paroi externe faisant face à l'extérieur du boîtier (500) et une paroi interne faisant face dans une direction opposée à la paroi externe.

4. Boîtier (500) de la revendication 3, ladite paroi externe de la première section (518a) présentant une première couleur d'une première série de couleurs, ladite paroi interne de la première section (518a) présentant une seconde couleur de la première série de couleurs, ladite paroi externe de la seconde section (518b) présentant une première couleur d'une seconde série de couleurs, et ladite paroi interne de la seconde section (518b) présentant une seconde couleur d'une seconde série de couleurs.

5. Boîtier (500) de la revendication 3, ladite paroi externe et ladite paroi interne de la première section (518a) étant colorées par la même série de couleurs selon l'anodisation primaire, et ladite paroi externe et ladite paroi interne de la seconde section (518b) étant colorées par la même série de couleurs selon l'anodisation secondaire qui est réalisée en continu après l'anodisation primaire.

6. Boîtier (500) de la revendication 1, ladite première section (518a) comprenant de multiples premières parties physiquement espacées les unes des autres.

7. Boîtier (500) de la revendication 1, ladite seconde section (518b) comprenant de multiples secondes parties physiquement espacées les unes des autres.

8. Dispositif électronique (101) comprenant le boîtier d'une quelconque revendication précédente.

9. Procédé de fabrication du boîtier (500) de l'une quelconque des revendications 1 à 7, le procédé comprenant :
le traitement du boîtier qui comprend l'élément latéral (518) ;
une anodisation primaire pour former un film d'oxyde prédéfini sur la première partie (518a) de l'élément latéral (518) ;
la coloration primaire du film d'oxyde formé sur la première section (518a) à l'aide d'un colorant présentant la première couleur ;
une anodisation secondaire pour former un film d'oxyde prédéfini sur la seconde section (518b) de l'élément latéral (518b) ; et
une coloration secondaire du film d'oxyde formé sur la seconde section (518b) à l'aide d'un colorant présentant la seconde couleur,
ladite première section (518a) et ladite seconde section (518b) étant espacées par des fentes (520a, 520b, 520d, 520e) formées dans l'élément latéral (518), et ledit boîtier (500) comprenant un matériau isolant (530) remplissant les fentes (520a, 520b, 520d, 520e).

10. Procédé de fabrication de boîtier de la revendication 9, comprenant en outre le prétraitement de la surface de l'élément latéral (518) pour obtenir un brillant et une planéité prédéfinis avant l'anodisation primaire.

11. Procédé de fabrication de boîtier de la revendication 9, comprenant en outre le scellement pour maintenir les performances et les propriétés des colorants sur les films d'oxyde, qui sont colorés, après l'anodisation primaire et l'anodisation secondaire.

12. Procédé de fabrication de boîtier de la revendication 9, ledit élément latéral (518) comprenant un alliage d'aluminium.
